(19) Europäisches Patentamt
European Patent Office
Office européen des brevets

(11) **EP 2 133 886 A1**

(12) **EUROPEAN PATENT APPLICATION**

(43) Date of publication:
**16.12.2009 Bulletin 2009/51**

(51) Int Cl.:
*H01F 7/02* (2006.01)   *G01C 19/60* (2006.01)
*G01R 33/20* (2006.01)

(21) Application number: **09162376.9**

(22) Date of filing: **10.06.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**

(30) Priority: **13.06.2008 US 157880**

(71) Applicant: **Northrop Grumman Guidance and Electronics Company, Inc.**
**Los Angeles, CA 90067-2101 (US)**

(72) Inventor: **Hall, David B.**
**La Crescenta, CA 91214 (US)**

(74) Representative: **Mackenzie, Andrew Bryan et al**
**Scott & York**
**Intellectual Property Limited**
**45 Grosvenor Road**
**St. Albans**
**Hertfordshire AL1 3AW (GB)**

(54) **Eight-fold dipole magnet array for generating a uniform magnetic field**

(57)     An array of permanent magnets (1-8) is arranged to produce a uniform magnetic field suitable for use in an NMR gyroscope cell. A magnet support structure (20) has a plurality of sockets (11-18) formed therein such that the plurality of sockets (11-18) is located at the vertices of a rectangular parallelepiped (24). A magnet (1-8) is mounted in each of the sockets (11-18), respectively, with each magnet (1-8) having a selected field strength and poling orientation. The magnets (1-8) preferably are of identical structure and field strength. The magnets (1 are preferably located in the sockets (12, 13,16, 17) on a first side (19) of the array (10) in pairs having polarities directed away from one another, and the magnets (1, 4, 5, 8) located in the sockets (11, 14, 15, 18) on a second side (21) of the array in pairs having polarities directed toward one another.

FIG. 1

**Description**

Background of the Invention

This invention relates generally to magnetic fields and particularly to magnetic fields for nuclear magnetic resonance (NMR) gyroscopes. Still more particularly this invention relates to apparatus and methods for producing a uniform magnetic field for application to an NMR gyroscope alkali-noble gas cell to provide maximal access of pump and detection light beams to the cell.

An NMR gyroscope alkali-noble gas cell requires a uniform magnetic field in the cell. The uniform magnetic field should be produced with a minimum amount of power. The prior art uses electromagnetic coils, which consume substantial amounts of electrical power.

Summary of the Invention

The present invention uses an array of permanent magnets to produce a uniform magnetic field in an NMR gyroscope cell. A method for forming a uniform magnetic field in an NMR cell placed at a selected location, comprising the steps of providing a magnet support structure; forming a plurality of sockets in the magnet support structure such that the plurality of sockets are located at the vertices of a rectangular parallelepiped; and forming a magnet array by mounting a magnet in each of the sockets with each magnet having a selected field strength and poling orientation.

The magnets preferably are of identical structure and field strength.

The method of the present invention preferably further comprises the steps of arranging the magnets located at the vertices on a first side of the array in pairs having polarities directed away from one another; and arranging the magnets located at the vertices on a second side of the array in pairs having polarities directed toward one another.

Brief Description of the Drawings

FIG. 1 is a perspective view showing an eight-fold dipole magnet array according to the present invention;

FIG. 2 is a perspective view showing a frame that may be used to hold the magnets of FIG. 1 in a specified array configuration;

FIG. 3 is a perspective view showing a first alternative structure for holding the magnets of FIG. 1 in the illustrated array;

FIG. 4 is a second alternative structure for holding the magnets of FIG. 1;

FIG. 5 graphically illustrates magnetic field intensities along x, y and z axes for the dipole magnet configuration of FIG. 1;

FIG. 6 illustrates an alternate configuration of an eight-fold dipole magnet configuration according to the present invention; and

FIG. 7 graphically illustrates magnetic field intensities along x, y and z-axes for the dipole magnet configuration of FIG. 6.

Detailed Description of the Invention

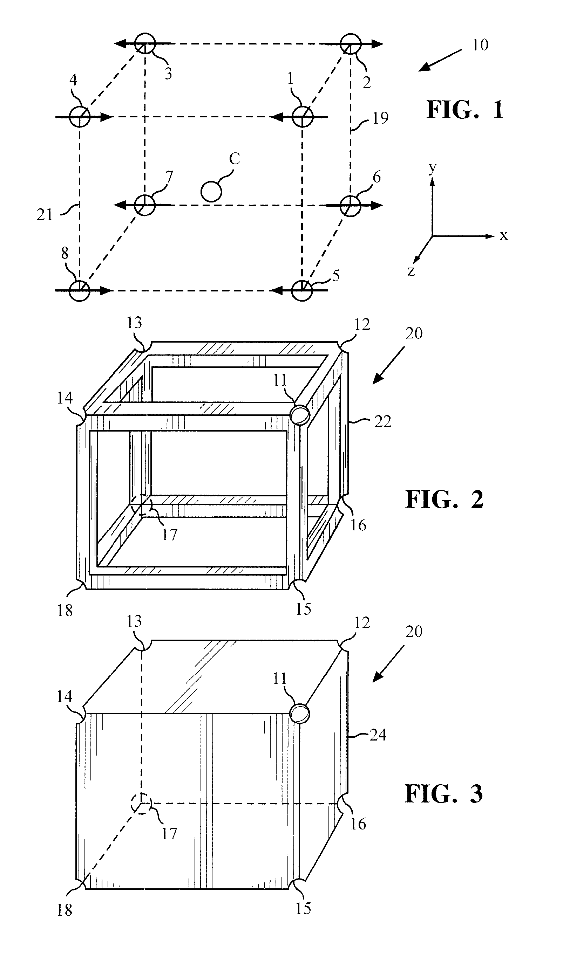

FIG. 1 illustrates an eight-fold dipole magnet array 10 according to the present invention. The magnet array 10 includes eight permanent magnets identified with reference numerals 1-8. The centers of the eight small spherical magnets 1-8 are located on corresponding corners of a rectangular volume that preferably extends 10 mm in the horizontal dimensions x and z and 5.744 mm in the vertical dimension y. The magnets 1-8 are uniformly poled along the $\pm$x-axes. Table 1 provides a list of the magnet locations and the poling directions.

FIG. 2 shows a frame 20 that may be formed to include a plurality of sockets 11-18 arranged hold the magnets 1-8, respectively, of the array 10 in their respective positions shown in FIG. 1. The frame 20 of FIG. 2 has a plurality of frame members 22 arranged to enclose a volume that is in the form of a rectangular parallelepiped with the sockets 11-18 are located at its eight corners. The magnets 1-8 may be retained in the corresponding sockets 11-18 by an adhesive.

The magnets 2 and 3 on a first side 19 of the array 10 are arranged to have their polarities aligned and pointing in opposite directions. The magnets 5 and 6 on the side 19 are also arranged to have their polarities aligned and pointing in opposite directions. The magnets 1 and 4 on a side 21 of the array 10 are arranged to have their polarities aligned and pointing toward one another. The magnets 5 and 8 on the side 21 are also arranged to have their polarities aligned and pointing toward one another.

FIG. 3 shows an alternative way of providing the sockets 11-18. FIG. 3 shows the sockets 11-18 formed at the corners of a solid rectangular parallelepiped 24. A passage may be formed in the rectangular parallelepiped 24 by any convenient means such as boring so that an NMR cell (not shown) may be placed at its center to be subject to the desired magnetic field.

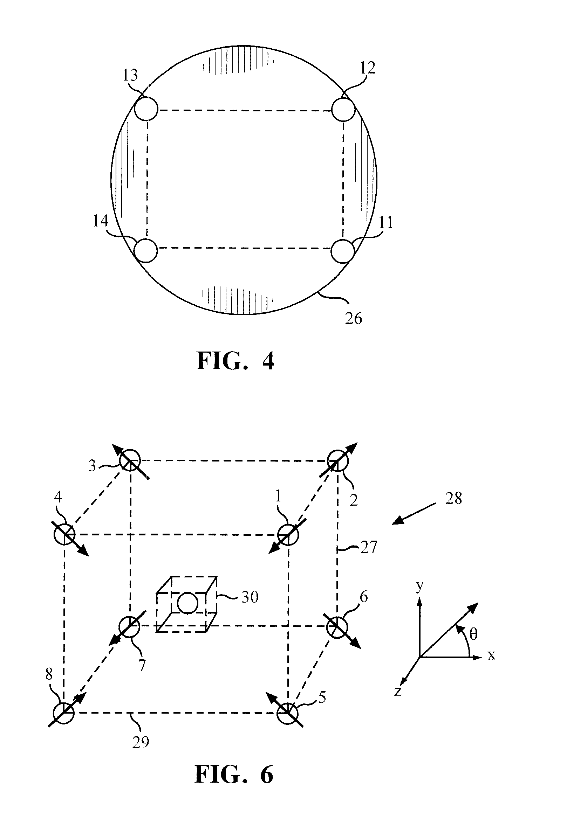

FIG. 4 shows a second alternative way of forming a support structure 26 for the magnets 1-8. FIG. 3 represents a top plan view of a cylinder having the sockets 11-14 formed at selected locations on the upper circular edge. The remaining sockets (not shown in FIG. 4) are formed in the bottom circular edge. Several additional ways of forming the support structure for the magnets are possible. The support structures presented herein are intended to be examples rather than a complete list.

An NMR cell (not shown) located in the center C of the rectangular array 10 exhibits a uniform magnetic field intensity along the z-axis and extremely small magnetic field intensities along the x and y axes. The magnitude of the magnetic field is a function of the pole strength of the individual magnets 1-8. For example, samarium cobalt spherical magnets having diameters of 0.47 mm and uniformly poled to a field strength of 10,000 Gauss produce a field of 1.0 Gauss in the center of the rectangular volume.

With no shielding, the exact solution for the magnetic field in the vicinity of a spherical uniformly poled permanent magnet is the same as that for the far field of a magnetic dipole. The magnetic field as a function of position may be expressed as:

$$\mathbf{B(r)} = \frac{[3\mathbf{n}(\mathbf{n} \bullet \mathbf{m}) - \mathbf{m}]}{|\mathbf{r}|^3}, \qquad (1)$$

where $\mathbf{B}$ is the magnetic field; $\mathbf{n}$ is a unit vector pointing from the magnet center to the observer's location; $\mathbf{m}$ is the magnetic moment of the magnet; and $\mathbf{r}$ is the vector distance from the magnet center to the observer's location. In terms of the pole strength $\mathbf{B_0}$, the magnetic moment is:

$$\mathbf{m} = \frac{a^3 \mathbf{B}_o}{3}, \qquad (2)$$

where $a$ is the radius of the sphere. At the point on the sphere where $\mathbf{n}$ and $\mathbf{m}$ are aligned, the magnetic field is also aligned to the magnetic moment $\mathbf{m}$ and has a field strength of 2/3 $\mathbf{B_0}$.

TABLE 1
MAGNET LOCATIONS AND POLING DIRECTIONS RELATIVE TO CENTER OF MAGNET ARRAY

| Magnet # | x (mm) | y (mm) | z (mm) | Poling Direction |
|---|---|---|---|---|
| 1 | +5 | +2.872 | +5 | -x |
| 2 | +5 | +2.872 | -5 | +x |
| 3 | -5 | +2.872 | -5 | -x |
| 4 | -5 | +2.872 | +5 | +x |
| 5 | +5 | -2.872 | +5 | -x |
| 6 | +5 | -2.872 | -5 | +x |
| 7 | -5 | -2.872 | -5 | -x |
| 8 | -5 | -2.872 | +5 | +x |

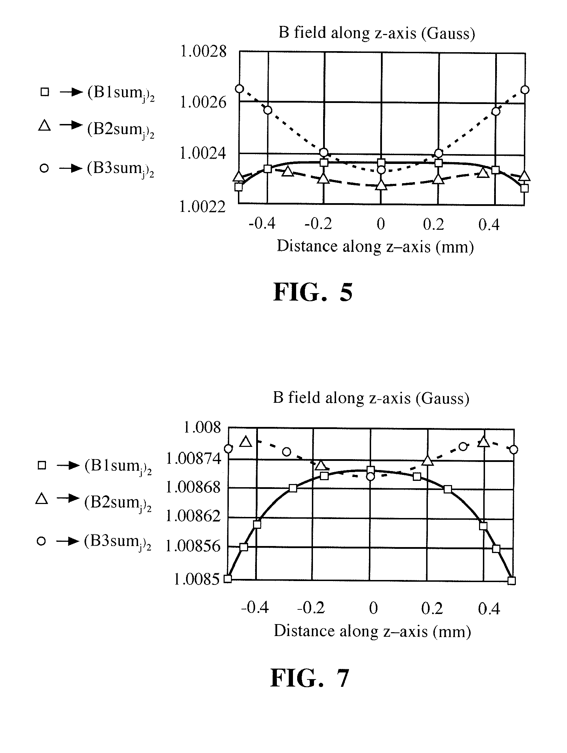

The solution to the magnetic field produced by the eight magnets 1-8 shown in FIG. 1 is the eight-fold superposition of Eq. (1) for a single magnet. A plot is shown in FIG. 5 to characterize the magnetic fields along the x, y, and z-axes in the central region C of the rectangular volume shown in FIG. 1. The spherical magnets 1-8 are preferably 0.47 mm in diameter and poled to a field strength of 10,000 gauss.

The plot shows three curves representing fields along the z-axis from - 0.5 mm to +0.5 mm from the center C. The solid curve indicted by squares is the field along the z-axis with x and y equal to zero. The dotted curve indicated by circles is the field at x = 0.4 mm and y = 0 whereas the black dashed curve indicated by triangles is the field at x = 0 and y = 0.4 mm. For an NMR cell with interior dimensions of 1.0 mm on a side, the solid line curve indicted by squares represents the field centered within the cell cross-section whereas the other two curves represent the field at a distance of 0.1 mm from the cell wall.

Table 2 is a summary of the magnetic field data for the array 10. The baseline is $B_z$ = 1.0 gauss, $B_x$ = 0, and $B_y$ = 0. Field variations are given in terms of parts per million (ppm) for the peak-to-peak range of all three curves on each plot referenced to one gauss.

TABLE 2
PEAK-TO-PEAK MAGNETIC FIELD VARIATIONS IN PPM

| Errors in poling strength, poling angle or location of one magnet | $B_z$ (ppm) | $B_x$ (ppm) | $B_y$ (ppm) |
|---|---|---|---|
| No errors | 400 | 200 | 0 |

(continued)

### PEAK-TO-PEAK MAGNETIC FIELD VARIATIONS IN PPM

| Errors in poling strength, poling angle or location of one magnet | $B_z$ (ppm) | $B_x$ (ppm) | $B_y$ (ppm) |
| --- | --- | --- | --- |
| 1.0% error in poling strength | 500 | 350 | 300 |
| 0.01 radian poling angle along y-axis | 600 | 500 | 100 |
| 0.01 radian poling angle along z-axis | 700 | 500 | 250 |
| 0.05 mm location error along x-axis | 1100 | 450 | 600 |
| 0.05 mm location error along y-axis | 1150 | 800 | 50 |
| 0.05 mm location error along z-axis | 1000 | 900 | 800 |

Table 2 shows that the magnetic field uniformity within the NMR cell located at the center C of the array 10 is of the order of several hundred ppm for no errors in magnet poling strength, magnet poling angle, or magnet location. Sizeable errors in these parameters introduce additional errors of several hundred ppm. This demonstrates the absence of excessive sensitivity of magnetic field variation to magnet poling and location errors.

Another eight-fold dipole magnet array 28 that produces a uniform magnetic field is shown in FIG. 6. The magnets 2 and 7 that are diagonally opposite on a side 27 of array 28 are arranged to have polarities that are aligned in pointing in opposite directions. The magnets 3 and 6 are also diagonally opposite and have aligned polarities pointing in opposite directions. The magnets 1 and 8 that are diagonally opposite on a side 29 of the array 28 are arranged to have polarities that are aligned and pointing toward one another. The magnets 4 and 5 on side 29 are also diagonally opposite and have aligned polarities that point toward one another. Table 3 gives a list of the magnet locations and the poling directions in the xy plane for the array 28. A pole strength of 10,000 Gauss requires a magnet diameter of 0.45 mm for a 1.0 Gauss filed in the center of the rectangular volume. In the array 28, the magnets 1, 2, 6 and 7 on a side 27 of the array 28 are arranged in pairs with their polarities at right angles to one another and pointing away from the center of the side 28. The magnets 1, 4, 5 and 8 on a side 29 are arranged in pairs having polarities that are at right angles to one another and that point toward the center of the side 29 of the array 28.

### TABLE 3
### MAGNET LOCATIONS AND POLING DIRECTIONS

| Magnet # | x (mm) | y (mm) | z (mm) | Poling angle in xy plane |
| --- | --- | --- | --- | --- |
| 1 | +4.09 | +4.09 | +5 | -135° |
| 2 | +4.09 | +4.09 | -5 | +45° |
| 3 | -4.09 | +4.09 | -5 | +135° |
| 4 | -4.09 | +4.09 | +5 | -45° |
| 5 | +4.09 | -4.09 | +5 | +135° |
| 6 | +4.09 | -4.09 | -5 | -45° |
| 7 | -4.09 | -4.09 | -5 | -135° |
| 8 | -4.09 | -4.09 | +5 | +45° |

As was done before for the magnet array 10 of FIG. 1, magnetic fields along x, y, and z are plotted from -0.5 mm to +0.5 mm along z. FIG. 7 show the fields with no errors in magnet poling strength, poling direction, and magnet location. Additional data is presented in Table 4 for seven magnets all equal in poling strength and with no errors in poling angle and magnet location. The eighth magnet has errors introduced in poling strength, poling angle, or location to determine the influence of these errors on magnetic field uniformity within the NMR cell located in the central region of the magnet array 20.

The sensitivity data is summarized in Table 4 for the array 20 in the same fashion as Table 2 for the first array 10.

### TABLE 4
### PEAK-TO-PEAK MAGNETIC FIELD VARIATIONS IN PPM

| Errors in poling strength, poling angle or location of one magnet | $B_z$ (ppm) | $B_x$ (ppm) | $B_y$ (ppm) |
| --- | --- | --- | --- |
| No errors | 300 | 200 | 0 |
| 1.0% error in poling strength | 650 | 450 | 350 |
| 0.01 radian poling angle along y-axis | 350 | 350 | 150 |
| 0.01 radian poling angle along z-axis | 450 | 400 | 350 |
| 0.05 mm location error along x-axis | 1050 | 400 | 600 |

(continued)

PEAK-TO-PEAK MAGNETIC FIELD VARIATIONS IN PPM

| Errors in poling strength, poling angle or location of one magnet | $B_z$ (ppm) | $B_x$ (ppm) | $B_y$ (ppm) |
|---|---|---|---|
| 0.05 mm location error along y-axis | 1050 | 600 | 50 |
| 0.05 mm location error along z-axis | 250 | 700 | 500 |

The results from Table 4 for the alternate magnet array 28 are similar to the results from Table 2 for the first magnet array 10.

Referring to FIG. 6, an NMR 30 cell in the middle of the rectangular volume is easily visualized as being another rectangular volume oriented along the x, y, and z-axes. The cell can also be rotated 45° about the z-axis for another orientation with maximum symmetry.

The analysis presented so far is exact with spherical, uniformly poled magnets with no shielding. In the far field limit for dipole magnets, Eq. (1) yields a solution that is independent of magnet shape. The two configurations presented here used magnets with a diameter of roughly ten percent of the distance from the magnet to the central field region. In this case, the magnet shape need not be spherical. Other shapes that would work include cubes poled along an edge or right circular cylinders poled along the cylinder axis.

The addition of a shield around the magnet assembly is necessary to eliminate stray magnetic fields. The relative locations of the magnets will change as the shield is introduced in order to keep a uniform field component $B_z$ at the center. With appropriate symmetry considerations for the shield, the rectangular solid volume with the magnets on the corners will be maintained with changes in its relative dimensions.

This type of reasoning is analogous to solenoid coil design with a secondary coil for maintaining a uniform field. The addition of a cylindrical shield necessitates a change in the length of the secondary coil relative to the length of the primary coil in order to maintain a very uniform field within the central region.

Auxiliary wire coils carrying extremely small currents can be placed in the vicinity of the magnet assembly to fine tune the central magnetic field for greater uniformity. Coils along three orthogonal axes can be used to fine tune the x, y, and z fields.

The magnets are all the same and can be mass produced and uniformly poled at the same time. The placement of the magnets on an assembly harness with some adjustment features is a way to minimize variations in the central magnetic field. Once the magnets have been made, they can be checked for diameter and poling strength before installation into an assembly harness.

**Claims**

1. A method for forming a uniform magnetic field at a selected location, comprising the steps of:

   providing a magnet support structure (20);
   forming a plurality of sockets (11-18) in the magnet support structure (20) such that the plurality of sockets (11-18) are located at the vertices of a rectangular parallelepiped (24); and
   forming a magnet array (10) by mounting a magnet (1-8) in each of the sockets (11-18) with each magnet (1-8) having a selected field strength and poling orientation.

2. The method of claim 1 wherein magnets (1-8) of identical structure and field strength are mounted in the sockets (11-18).

3. The method of claim 2, further comprising the steps of:

   arranging the magnets (2, 3, 6, 7) located in the sockets (12, 13, 16, 17), respectively, on a first side (19) of the array (10) in pairs with magnets having polarities directed away from one another; and
   arranging the magnets (1, 4, 5, 8) located in the sockets (11, 14, 15, 18) on a second side (21) of the array (10) in pairs having polarities directed toward one another.

4. The method of claim 1, further comprising the step of arranging the magnets (1-8) in an array (28) wherein the magnets (2, 3, 6, 7) are arranged in pairs at opposite corners of a side (27) with polarities that point in opposite directions and wherein the magnets (1, 4, 5, 8) are arranged in pairs at opposite corners of a side (29) with polarities that point toward one another.

5. Apparatus for forming a uniform magnetic field at a selected location, comprising:

   a magnet support structure (20) having a plurality of sockets (11-18) formed therein with the plurality of sockets (11-18) being located at the corners of a rectangular parallelepiped (24); and
   a magnet array (10) comprising a magnet (1-8) mounted in each of the sockets (11-18), respectively, with each magnet (1-8) having a selected field strength and poling orientation.

6. The apparatus of claim 5 wherein magnets (1-8) have identical structure and field strength.

7. The apparatus of claim 6 wherein the magnets (2, 3, 6, 7) located in the sockets (12, 13, 16, 17) on a first side (19) of the array (10) are arranged in pairs having polarities directed away from one another and the magnets (1, 4, 5, 8) located in the sockets (11, 14, 15, 18) on a second side (21) of the array (10) are arranged in pairs having polarities directed toward one another.

FIG. 1

FIG. 2

FIG. 3

FIG. 4

FIG. 6

B field along z-axis (Gauss)

$\square \rightarrow (B1sum_j)_2$

$\triangle \rightarrow (B2sum_j)_2$

$\circ \rightarrow (B3sum_j)_2$

1.0028

1.0026

1.0024

1.0022

-0.4    -0.2    0    0.2    0.4

Distance along z–axis (mm)

## FIG. 5

B field along z-axis (Gauss)

$\square \rightarrow (B1sum_j)_2$

$\triangle \rightarrow (B2sum_j)_2$

$\circ \rightarrow (B3sum_j)_2$

1.008

1.00874

1.00868

1.00862

1.00856

1.0085

-0.4    -0.2    0    0.2    0.4

Distance along z–axis (mm)

## FIG. 7

**EP 2 133 886 A1**

Europäisches Patentamt
European Patent Office
Office européen des brevets

# EUROPEAN SEARCH REPORT

Application Number

EP 09 16 2376

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2006/139029 A1 (ABBINK HENRY C [US] ET AL) 29 June 2006 (2006-06-29) * abstract * * paragraphs [0012], [0016] * ----- | 1,5 | INV. H01F7/02 G01C19/60 G01R33/20 |
| X | US 3 103 620 A (FRASER JULIUS T) 10 September 1963 (1963-09-10) * abstract * * column 3, line 70 - column 4, line 3 * * column 4, lines 37-40 * ----- | 1,5 | |
| A | US 3 909 706 A (GRESCINI JEAN ET AL) 30 September 1975 (1975-09-30) * abstract * * column 2, lines 16-20 * ----- | 1-7 | |

| | |
|---|---|
| | TECHNICAL FIELDS SEARCHED (IPC) |
| | G01C G01R H01F |

The present search report has been drawn up for all claims

| Place of search | Date of completion of the search | Examiner |
|---|---|---|
| Munich | 7 October 2009 | Winkelman, André |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 09 16 2376

This annex lists the patent family members relating to the patent documents cited in the above-mentioned European search report.
The members are as contained in the European Patent Office EDP file on
The European Patent Office is in no way liable for these particulars which are merely given for the purpose of information.

07-10-2009

| Patent document cited in search report | | Publication date | Patent family member(s) | | Publication date |
|---|---|---|---|---|---|
| US 2006139029 | A1 | 29-06-2006 | NONE | | |
| US 3103620 | A | 10-09-1963 | NONE | | |
| US 3909706 | A | 30-09-1975 | CA | 1000357 A1 | 23-11-1976 |
| | | | CH | 574605 A5 | 15-04-1976 |
| | | | DE | 2347149 A1 | 28-03-1974 |
| | | | FR | 2213500 A1 | 02-08-1974 |
| | | | GB | 1426236 A | 25-02-1976 |
| | | | IT | 1009036 B | 10-12-1976 |
| | | | JP | 1166662 C | 08-09-1983 |
| | | | JP | 49094375 A | 07-09-1974 |
| | | | JP | 57035427 B | 29-07-1982 |
| | | | NL | 7312888 A | 22-03-1974 |

EPO FORM P0459

For more details about this annex : see Official Journal of the European Patent Office, No. 12/82